Europäisches Patentamt

European Patent Office

Office européen des brevets

(11) Publication number: **0 207 800**
A1

## (12) EUROPEAN PATENT APPLICATION

(21) Application number: 86305183.5

(22) Date of filing: 03.07.86

(51) Int. Cl.⁴: **G 01 R 15/07**
**G 02 F 1/21**

(30) Priority: 03.07.85 US 751658

(43) Date of publication of application:
07.01.87 Bulletin 87/2

(84) Designated Contracting States:
BE CH DE FR GB IT LI NL

(71) Applicant: WESTINGHOUSE ELECTRIC CORPORATION
Westinghouse Building Gateway Center
Pittsburgh Pennsylvania 15235(US)

(72) Inventor: Boenning, Robert Allen
2116 Forest Ridge
Timonium Maryland 21093(US)

(72) Inventor: Vaerewyck, Eugene Gerard
2512 Punta Devista, NE
Albuquerque New Mexico 87112(US)

(74) Representative: van Berlyn, Ronald Gilbert
23, Centre Heights
London, NW3 6JG(GB)

(54) Electro-optical comparator.

(57) Apparatus for comparing a voltage signal ($V_x$) to a reference voltage signal ($V_{ref}$) using optical techniques, is described. The comparison is performed by dividing a common optical beam (18,32) into two beams (12,14) which are transmitted along optical delay lines formed in an electro-optical substrate (10). Electrodes (40,42,46,48,50) are provided on the surface of the electro-optical substrate (10) to modify the delays such that by combining the output of the two optical signals, a comparison between the signal being tested and a reference voltage is produced.

FIG. 1

FIG. 2

FIG. 3

RELATIVE PHASE ANGLE – $\phi$

EP 0 207 800 A1

1

# ELECTRO-OPTICAL COMPARATOR

The invention relates to test apparatus and, more specifically, to apparatus for comparing an electrical signal to a reference signal utilizing electro-optical transmission line interferometers to determine the relationship therebetween.

Interferometers using optical delay lines formed in electro-optical substrates are well known and extensively discussed in the prior art. In the most widely used embodiment, these interferometers use titanium infused into lithium niobate substrates to produce the optical wave guides. However, no specific prior art electro-optical devices have been capable of comparing an unknown electrical voltage to a reference voltage to determine the relationship therebetween.

Therefore, a principal object of invention is to provide an electro-optical comparator capable of comparing a received unknown signal and comparing it with a reference signal to determine the relationship between the two signals.

With this object in view, the invention resides in an optical comparator for comparing a first unknown and a second reference electrical signal and for generating an optical output signal corresponding to a predetermined relationship between said first and second electrical signals; comprising an electro-optical substrate including first and second sections of optical waveguide joining at a first common junction to form a first common section, said first common section terminating at an optical input port, said first and second sections also joining at a second common junction to form a second common section, said second common section terminating at an optical output port characterized by an electrode means affixed to the surface of said substrate adapted to selectively subject said first and second sections to electrical fields to produce at said optical output port an optical signal corresponding to a predetermined relationship between (1) said first and second electrical signals.

The preferred embodiment of the invention will be described, by way of example, with reference to the accompanying drawings in which:

Figure 1 is a top view of the preferred embodiment of the invention;

Figure 2 is an alternate embodiment of the invention; and

Figure 3 is a diagram illustrating the optical output of the comparator as a function of the ratio of the unknown signal to the reference signal.

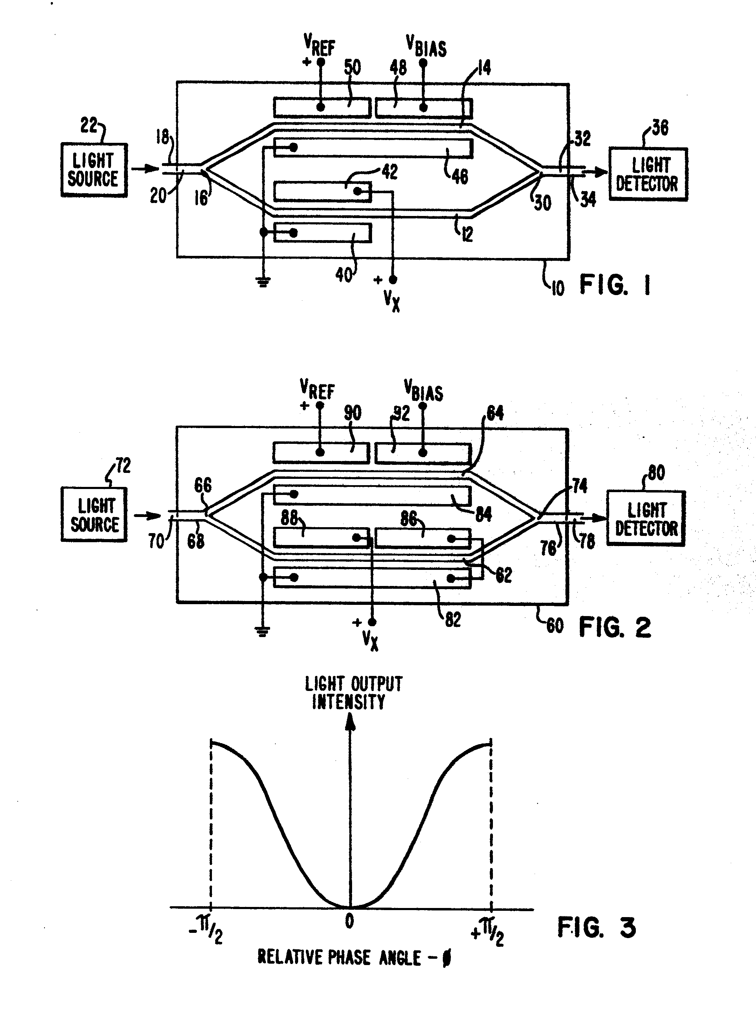

Figure 1 is a top view of the preferred embodiment of the invention. A lithium niobate substrate 10 is utilized to form the electro-optically active portions of the invention.

Two parallel sections of optical wave guide, 12 and 14, are formed in the substrate 10 by infusing titanium into the substrate 10 using well-known prior art techniques. The two sections of optical wave guide, 12 and 14, join at a first junction 16 to form a common section of optical wave guide 18. The section of optical wave guide 18 extends to the edge of the substrate 10 to form an optical input port 20 to which an optical signal from a light source 22 is coupled.

Similarly, the parallel sections of optical wave guide, 12 and 14, join at a second junction 30 and are coupled by a common section of optical wave guide 32 to the edge of the optical substrate 10 to form an optical output port 34. Optical energy from the optical output port 34 is coupled to a conventional optical detector 36.

In Figure 1, first and second electrodes, 40 and 42, are affixed to the surface of the lithium niobate substrate 10 such that they are positioned substantially parallel to the straight section 12 of optical wave guide. In this embodiment, the first electrode 40 is coupled to ground (reference potential) and the second electrode 42 is coupled to the voltage "$V_X$" which is to be compared to a reference voltage "$V_{ref}$". As is well known, applying a voltage to electrode 42 will produce an electric field which results in a change of the optical delay produced by the substantially straight section 12 of optical wave guide.

Three electrodes, 46, 48 and 50, are affixed to the upper surface of the optical substrate 10 and extend substantially parallel to optical waveguide 14. A first electrode 46 extends substantially the entire length of the straight section of optical wave guide 14 while the electrodes, 48 and 50, are each substantially equal to one-half of the length of the straight section of optical wave guide 14. A reference electrode for subjecting the optical wave guide 14 to various electric fields is provided by coupling the longer electrode 46 to a ground or reference potential. A bias signal and reference signal are respectively connected to electrodes, 48 and 50. The bias and reference signals produce electric fields across waveguide section 14 changing the delay through the waveguide.

In operation, the comparator is calibrated by coupling the same voltage to the reference and comparison electrodes, 40 and 50. These voltages can be either positive, negative or zero so long as they are identical in instantaneous amplitude and polarity. A DC bias voltage is coupled to the bias electrode 48 and adjusted until the optical output signal at output port 34 is equal to zero. This occurs when the optical delay difference between the parallel sections of optical wave guide, 12 and 14, is equal to 180°. Under these circumstances, the optical input signal coupled to waveguide 18 divides into equal parts at common node 16. The two optical signals transmitted through these paths are merged at the common junction 30 and since they are 180° out-of-phase, the optical output signal at optical output port 34 decreases to zero. The phase shift is a function of the delay and is a continuous function. Thus, as the bias signal is adjusted, the optical output at optical output port 34 does not switch to zero, but decreases continuously until it approaches zero.

Following adjustment of the comparator, a reference signal is applied to the reference electrode 50 and the signal whose status is to be determined is coupled to the comparison electrode 42. When these two are identical in instantaneous phase and amplitude, the optical output will remain zero. However, if they are different in either instantaneous phase or amplitude, the optical signals transmitted through the two parallel sections of optical wave guide 12 and 14 will have either more or less than 180° phase shift resulting in these signals combining at common junction 30 to produce an optical output signal at optical output port 34. As previously described, this is a continuous and substantially linear function with the output signal being a function of the phase difference between the optical signals arriving at the common junction 30.

Figure 2 is a top view of a second embodiment of the invention. Similar to the embodiment illustrated in Figure 1, this embodiment utilizes a lithium niobate substrate 60. Infused in the upper surface of the lithium niobate substrate 60 are two parallel sections of optical wave guide, 62 and 64. As in the previous described preferred embodiment, the sections of optical wave guide, 62 and 64, join at a first junction 66 and are coupled by a common section of optical wave guide 68 to an optical input port 70. An optical signal is provided to the optical input port 70 by a conventional light source 72. Additionally, the sections of optical wave guide, 62 and 64 join at a second common junction 74. A common section of optical wave guide 76 extends between the second junction 74 and an optical output port 78. Optical energy emerging from the output optical port 78 is detected by a conventional light detector 80.

The velocity of light propagation through the parallel sections of optical wave guide, 62 and 64, is modulated by coupling various voltage signals to electrodes affixed to the upper surface of the lithium niobate substrate 60. More specifically, two electrodes, 82 and 84, are affixed to the upper surface of the lithium niobate substrate 60 and extend substantially the entire length of the straight sections, 62 and 64, of optical wave guide. Four electrodes, 86 through 92, each having a length slightly less than one-half the length of the parallel sections of optical wave guide are affixed to the upper surface of the substrate 60.

The electrode arrangement illustrated in Figure 2 offers great flexibility in utilizing a plurality of voltage signals to modulate the phase shifts through the parallel sections of optical wave guide, 62 and 64. However, to illustrate its operation in a manner similar to that in Figure 1, electrodes 82, 84 and 86 have been connected together and coupled to a ground reference potential. This assures that the electrode 86 does not affect the propagation delay through parallel sections of optical wave guide 62.

In this configuration, the DC bias signal is coupled to electrode 92 and is used to calibrate the comparator in a manner similar to the embodiment illustrated in Figure 1 and discussed above. The reference and the unknown signals are then coupled to electrodes 88 and 90 and this embodiment essentially functions identical to the one illustrated in Figure 1. However, it should be pointed out that it is not necessary to connect the additional electrode 86 to electrode 92 but this electrode could be provided with a separate input terminal. If this is done, electrode 86 provides an additional electrode for further modulating the phase differences in signals transmitted through the parallel sections of optical wave guide 60 and 62. However, in all cases, the optical energy transmitted through these sections is combined at the common junction 74 in either a constructive or destructive manner depending upon the relative phase shift.

Figure 3 is a graph illustrating the optical output as a function of the absolute value of the ratio of the unknown signal to the reference signal assuming that the bias signal has been adjusted as described with reference to Figure 1 to minimize the optical output signal when the reference and unknown signals are of identical amplitude and polarity. For example, when the ratio of $V_X$ to $V_{ref}$ is equal to one, the optical output is zero. As this ratio changes in a positive direction, the optical output increases to a maximum value. Similarly, when the ratio increases in a negative direction, a similar saturation point is reached. However, it should be pointed out that once the saturation has been reached in either the positive or negative direction, the output may again decrease due to the fact that the relative phase difference between the two parallel optical paths has exceeded 180° and again becomes additive at the common junction 30 of Figure 1.

7

CLAIMS:

1. An optical comparator for comparing a first unknown and a second reference electrical signal and for generating an optical output signal corresponding to a predetermined relationship between said first and second electrical signals; comprising an electro-optical substrate including first and second sections of optical waveguide joining at a first common junction to form a first common section, said first common section terminating at an optical input port, said first and second sections also joining at a second common junction to form a second common section, said second common section terminating at an optical output port characterized by electrode means affixed to the surface of said substrate adapted to selectively subject said first and second sections to electrical fields to produce at said optical output port an optical signal corresponding to a predetermined relationship between (1) said first and second electrical signals.

2. An optical comparator in accordance with claim 1 characterized by the optical lengths of said first and second sections being substantially identical when the electrical fields to which said first and second sections are subjected have substantially identical orientation and intensity distribution.

3. An optical comparator in accordance with claim 2 characterized by said electrode means being adapted to accept a first signal for adjusting the electric field to which at least one of said first and second sections are subjected such that the optical signal at said optical output port is substantially zero and is substantially independent of the optical input signal at said optical input port.

0207800

**FIG. 1**

V_REF
V_BIAS

LIGHT SOURCE

LIGHT DETECTOR

**FIG. 2**

V_REF
V_BIAS

LIGHT SOURCE

LIGHT DETECTOR

**FIG. 3**

LIGHT OUTPUT INTENSITY

$-\pi/2$  0  $+\pi/2$

RELATIVE PHASE ANGLE — $\phi$

| Category | Citation of document with indication, where appropriate, of relevant passages | Relevant to claim | CLASSIFICATION OF THE APPLICATION (Int. Cl.4) |
|---|---|---|---|
| P,X | FR-A-2 574 943 (THOMSON CSF) * Page 3, line 9 - page 4, line 33; claims 1-4,8; figures 1-3 * | 1 | G 01 R 15/07 G 02 F 1/21 |
| Y | FR-A-2 508 754 (CGE) * Page 4, lines 23-34; claim 1; figures 1,2 * | 1-3 | |
| Y | EP-A-0 020 216 (THOMSON-CSF) * Page 3, line 5 - page 8, line 20; page 11, line 19 - page 12, line 7; claims 1-3,8; figures 1-5 * | 1-3 | |
| A | DE-A-3 127 406 (SIEMENS AG) | | |
| A | ADVANCES IN INSTRUMENTATION, vol. 37., part 3, 1982, pages 1655-1671, ISA, Research Triangle Park, NC, US; A.R. TEBO: "Sensing with optical fibers: an emerging technology" | | |

TECHNICAL FIELDS SEARCHED (Int. Cl.4)

G 01 R
G 02 F

The present search report has been drawn up for all claims

| Place of search | Date of completion of the search | Examiner |
|---|---|---|
| THE HAGUE | 17-10-1986 | ROSE A.R.P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document